# EUROPÄISCHE PATENTSCHRIFT

(11) **EP 1 440 610 B1**
(45) Veröffentlichungstag und Bekanntmachung des Hinweises auf die Patenterteilung: **13.12.2006**
(21) Anmeldenummer: 02776828.2
(22) Anmeldetag: 16.10.2002
(51) Int. Cl.: H05K 7/14

(54) **AUTOMATISIERUNGSGERÄT MIT EINEM ELEKTRISCH ANSTEUERBAREN BESCHRIFTUNGSFELD ZUR BEZEICHNUNG DER AUSSENANSCHLÜSSE**
AUTOMATIZATION DEVICE COMPRISING AN ELECTRICALLY CONTROLLED LABELING FIELD FOR DESIGNATING EXTERNAL CONNECTIONS
APPAREIL D'AUTOMATISATION COMPRENANT UN CHAMP D'INSCRIPTIONS A COMMANDE ELECTRIQUE QUI PERMET D'IDENTIFIER DES CONNEXIONS EXTERNES

(30) Priorität: 24.10.2001 DE 10152348
(43) Veröffentlichungstag der Anmeldung: 28.07.2004
(73) Patentinhaber: SIEMENS AKTIENGESELLSCHAFT, 80333 München (DE)
(72) Erfinder: BOCK, Günther, 92245 Kümmersbruck (DE)
(86) Internationale Anmeldenummer: PCT/DE2002/003919
(87) Internationale Veröffentlichungsnummer: WO 2003/039221

(56) Entgegenhaltungen:
- DE-A- 3 243 132
- GB-A- 2 223 884
- US-A- 5 541 810

## Beschreibung

Die Erfindung betrifft ein Automatisierungsgerät mit Außenanschlüssen gemäß dem Oberbegriff des Anspruchs 1.

Ein derartiges Automatisierungsgerät ist z.B. aus der DE 36 03 750 oder aus der US 5 541 810 oder aus der EP 0 162 373 bekannt oder z.B. als Automatisierungsgerät mit der Bezeichnung Simatic S7-300 bzw. Simatic S7-400 der Siemens AG bekannt.

Der Begriff Automatisierungsgerät bezeichnet sowohl ein Gesamtgerät als auch einzelne sogenannte Module oder Baugruppen, die zu einem Gesamtgerät kombinierbar sind.

Die Automatisierungsgeräte der DE 36 03 750 weisen an einer für den Benutzer oder Bediener sichtbaren Frontseite eine Anzahl von Bezeichnungsfeldern auf. Jedes Bezeichnungsfeld ist einem Außenanschluss zugeordnet, so dass der Benutzer oder Bediener anhand der auf dem Bezeichnungsfeld eingetragenen Bezeichnung über die Funktionalität des jeweiligen Außenanschlusses informiert ist. Die Bezeichnung wird von Hand in das Bezeichnungsfeld eingetragen.

Das Eintragen einer Bezeichnung in ein Bezeichnungsfeld ist in nachteiliger Weise fehleranfällig, weil sich nicht gewährleisten lässt, dass das einem Außenanschluss zugeordnete Bezeichnungsfeld korrekt beschriftet wird. Zudem ist das händische Ausfüllen eines Bezeichnungsfeldes arbeitsaufwendig.

Der Erfindung liegt daher die Aufgabe zugrunde ein Automatisierungsgerät anzugeben, bei dem diese Nachteile vermieden werden.

Diese Aufgabe wird erfindungsgemäß mit den Merkmalen des Anspruchs 1 gelöst. Dazu ist bei einem Automatisierungsgerät mit Außenanschlüssen und einer Frontseite, wobei jedem Außenanschluss insbesondere an der Frontseite ein Bezeichnungsfeld zugeordnet ist, das oder jedes Bezeichnungsfeld ein elektrisch ansteuerbares Bezeichnungsfeld.

Der Vorteil der Erfindung besteht darin, dass mit einem derartigen Automatisierungsgerät Inkonsistenzen zwischen einer Projektierung eines Prozesssignals, der Darstellung am Bezeichnungsfeld und der realen Verdrahtung vermeidbar sind. Die damit mit der Projektierung/Programmierung sichergestellte Konsistenz der Darstellung am Bezeichnungsfeld erleichtert zudem das Verdrahten des Automatisierungsgerätes.

Es ist allgemein üblich, dass bei der Programmierung eines Automatisierungsgerätes oder bei der Projektierung eines Automatisierungsvorhabens für die einzelnen Signale vom oder zum externen technischen Prozess Signalnamen vergeben werden, die die Lesbarkeit und damit die Wartbarkeit solcher Projektierungen oder derartiger Programme erleichtert. Ein Signal, das von einem an einem Gleisende positionierten Endschalter geliefert wird, wird entsprechend z.B. als "Endschalter Gleisende" bezeichnet. Ein Signal, das von einem Füllstandswächter in einem Silo geliefert wird, wird entsprechend z.B. als "Silo voll" bezeichnet, usw. Diese Signale gelangen über eine entsprechende Verdrahtung an den Außenanschlüssen in das Automatisierungsgerät. Damit liegt es nahe, das Signal und die Leitung, über die das Signal übertragen wird, bzw. den Außenanschluss, an dem die Leitung aufgelegt ist mit der gleichen Bezeichnung zu versehen.

Bisher wurde diese Bezeichnung von Hand in entsprechende Bezeichnungsfelder eingetragen. Wenn das Bezeichnungsfeld ein elektrisch ansteuerbares Bezeichnungsfeld ist, kann die jeweilige Bezeichnung für jedes Bezeichnungsfeld auf elektrischem Wege vorgegeben werden und dazu insbesondere anhand von Daten, die nach der Programmierung des Automatisierungsgerätes oder nach der Projektierung des Automatisierungsvorhabens ohnehin schon vorliegen, gewonnen werden.

Vorteilhafte Ausgestaltungen der Erfindung sind Gegenstand der Unteransprüche.

Wenn auch die Außenanschlüsse zur Frontseite der sich das oder jedes Bezeichnungsfeld befindet, geführt sind, ist eine augenfällige Zuordnung eines Außenanschlusses zum jeweiligen Bezeichnungsfeld möglich.

Wenn das oder jedes Bezeichnungsfeld ein alphanumerisches Bezeichnungsfeld ist, können Signalbezeichnungen im Klartext in gleicher Form dargestellt werden, wie sie auch in einer Dokumentation ausgewiesen sind.

Wenn das oder jedes Bezeichnungsfeld ein Punkt-Matrix-Feld ist, ergibt sich eine erweiterte Darstellungsmöglichkeit, so dass z.B. auch Sonderzeichen darstellbar sind oder dass etwa die Bezeichnung jedes Mal, wenn ein Wechsel im Status des jeweiligen Signals erfolgt die Darstellung der Bezeichnung invertiert wird. Bei einem anstehenden Signal könnte die Bezeichnung mit heller Schrift auf dunklem Untergrund und bei einem nicht anstehenden Signal entsprechend mit dunkler Schrift auf hellem Untergrund erfolgen. Selbstverständlich können bei entsprechender Leistungsfähigkeit des Bezeichnungsfeldes hier auch Farben sinnvoll eingesetzt werden. Insgesamt wird damit die Möglichkeit eröffnet, auf Leuchtdioden, die heute vielfach den Signalzustand anzeigen, verzichten zu können.

Schließlich ist das oder jedes Bezeichnungsfeld vorteilhaft mittels OLED-Technologie realisiert.

Gemäß einem Ausführungsbeispiel der Erfindung wird der Papierstreifen der genannten Automatisierungsgeräte S7-300 bzw. S7-400 durch eine elektronische Anzeige ersetzt.

Darin zeigt die einzige Figur
ein Automatisierungsgerät mit einem elektrisch ansteuerbaren Bezeichnungsfeld.

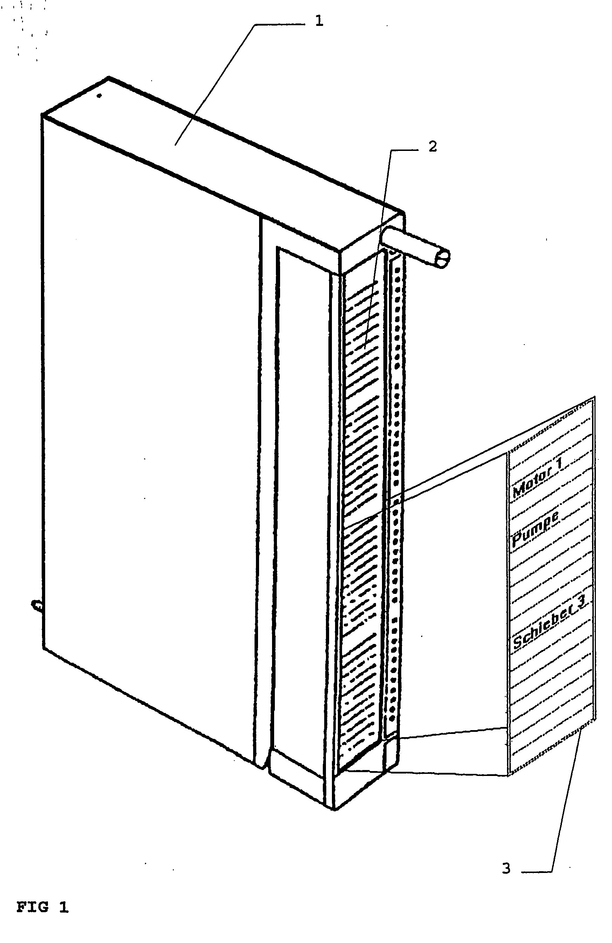

Die FIG 1 zeigt ein an sich bekanntes Automatisierungsgerät 1 wie es zum Beispiel in der EP 0 162 373 beschrieben ist. Das bekannte Automatisierungsgerät weist an einer Frontseite 2 ein Bezeichnungsfeld 2 auf. In einem solchen Bezeichnungsfeld, das z.B. einen Papierstreifen beinhaltet, werden bisher manuell Einträge vorgenommen, um die diversen Außenanschlüsse des Automatisierungsgerätes 1 zu bezeichnen.

Gemäß der Erfindung ist vorgesehen, das bisherige Bezeichnungsfeld durch ein elektrisch ansteuerbares Bezeichnungsfeld 3 zu ersetzen.

Das elektrisch ansteuerbare Bezeichnungsfeld 3 bietet die Möglichkeit jeweils Gruppen von alphanumerischen Zeichen in einer Anzahl von Zeilen darzustellen, wobei jeweils eine Zeile des elektrisch ansteuerbaren Bezeichnungsfeldes 3 einem Außenanschluss des Automatisierungsgerätes 1 zugeordnet ist.

Bei z.B. 32 Außenanschlüssen des Automatisierungsgerätes umfasst das elektrisch ansteuerbare Bezeichnungsfeld 3 entsprechend 32 Zeilen oder es werden zwei elektrisch ansteuerbare Bezeichnungsfelder 3 mit jeweils 16 Zeilen oder vier elektrisch ansteuerbare Bezeichnungsfelder 3 mit jeweils 8 Zeilen vorgesehen.

Damit lässt sich die Erfindung kurz wie folgt darstellen:

Es wird ein Automatisierungsgerät mit Außenanschlüssen angegeben, bei dem ein elektrisch ansteuerbares Beschriftungsfeld zur Bezeichnung der Außenanschlüsse vorgesehen ist.

## Patentansprüche

1. Automatisierungsgerät (1) mit Außenanschlüssen und einer Frontseite (2), wobei jedem Außenanschluss insbesondere an der Frontseite (2) ein Bezeichnungsfeld zugeordnet ist,
**ddadurch gekennzeichnet, dass** das oder jedes Bezeichnungsfeld ein elektrisch ansteuerbares Bezeichnungsfeld (3) ist.

2. Automatisierungsgerät nach Anspruch 1,
wobei die Außenanschlüsse zur Frontseite geführt sind.

3. Automatisierungsgerät nach Anspruch 1 oder 2,
wobei das Bezeichnungsfeld (3) ein alphanumerisches Bezeichnungsfeld (3) ist.

4. Automatisierungsgerät nach Anspruch 1, 2 oder 3,
wobei das Bezeichnungsfeld (3) ein Punkt-Matrix-Feld (3) ist.

5. Automatisierungsgerät nach Anspruch 1, 2, 3 oder 4,
wobei das Bezeichnungsfeld (3) mittels OLED-Technologie (3) realisiert ist.

## Claims

1. Programmable controller (1) with external terminals and a front side (2), each external terminal being assigned, in particular on the front side (2), a labeling field, **characterized in that** the or each labeling field is an electrically activatable labeling field (3).

2. Programmable controller according to Claim 1, the external terminals being led to the front side.

3. Programmable controller according to Claim 1 or 2, the labeling field (3) being an alphanumeric labeling field (3).

4. Programmable controller according to Claim 1, 2 or 3, the labeling field (3) being a dot-matrix field (3).

5. Programmable controller according to Claim 1, 2, 3 or 4, the labeling field (3) being realized by means of OLED technology.

## Revendications

1. Appareil d'automatisation (1) ayant des bornes extérieures et une façade (2), un champ d'inscription étant associé à chaque borne extérieure notamment sur la façade (2), **caractérisé par le fait que** le ou chaque champ d'inscription est un champ de désignation (3) électriquement commandable.

2. Appareil d'automatisation selon la revendication 1, dans lequel les bornes extérieures sont amenées jusqu'à la façade.

3. Appareil d'automatisation selon la revendication 1 ou 2, dans lequel le champ de désignation (3) est un champ de désignation alphanumérique (3).

4. Appareil d'automatisation selon la revendication 1, 2 ou 3, dans lequel le champ de désignation (3) est un champ à matrice de points (3).

5. Appareil d'automatisation selon la revendication 1, 2, 3 ou 4, dans lequel le champ de désignation (3) est réalisé au moyen d'une technologie OLED (3).
